# FASCICULE DE BREVET EUROPEEN

(11) **EP 4 264 691 B1**
(45) Date de publication et mention de la délivrance du brevet: **14.10.2026**
(21) Numéro de dépôt: 21851682.1
(22) Date de dépôt: 15.12.2021
(51) Int. Cl.: H10N 30/60, H10N 30/85, H10N 30/857, H10N 30/074

(54) **ARTICLE COMPOSITE À BASE D'UNE MATRICE THERMOPLASTIQUE INTÉGRANT AU MOINS UN TRANSDUCTEUR COMPRENANT UN POLYMÈRE PIÉZOÉLECTRIQUE**
VERBUNDARTIKEL AUF DER BASIS EINER THERMOPLASTISCHEN MATRIX MIT MINDESTENS EINEM WANDLER, DER EIN PIEZOELEKTRISCHES POLYMER ENTHÄLT
COMPOSITE ARTICLE BASED ON A THERMOPLASTIC MATRIX INCORPORATING AT LEAST ONE TRANSDUCER COMPRISING A PIEZOELECTRIC POLYMER

(30) Priorité: 16.12.2020 FR 2013378
(43) Date de publication de la demande: 25.10.2023
(73) Titulaire: ARKEMA FRANCE, 92800 Puteaux (FR)
(72) Inventeur: DOMINGUES DOS SANTOS, Fabrice, 92705 Colombes Cedex (FR); SOULESTIN, Thibaut, 69491 Pierre-Bénite Cedex (FR); FRANCOIS, Gilles, 69491 Pierre-Bénite Cedex (FR); GERARD, Pierre, 64170 Lacq (FR)
(74) Mandataire: Arkema Patent
(86) Numéro de dépôt international: PCT/FR2021/052350
(87) Numéro de publication internationale: WO 2022/129793

(56) Documents cités:
- WO-A1-2022/055610
- BAEG KANG-JUN ET AL: "Low-voltage, high speed inkjet-printed flexible complementary polymer electronic circuits", ORGANIC ELECTRONICS, ELSEVIER, AMSTERDAM, NL, vol. 14, no. 5, 19 March 2013 (2013-03-19), pages 1407 - 1418, XP028579693, ISSN: 1566-1199, DOI: 10.1016/J.ORGEL.2012.12.022
- CHEN XIAOLIANG ET AL: "Nanowire-based flexible P(VDF-TrFE) nanogenerator for simultaneously harvesting mechanical and thermal energies", 2015 IEEE 15TH INTERNATIONAL CONFERENCE ON NANOTECHNOLOGY (IEEE-NANO), IEEE, 27 July 2015 (2015-07-27), pages 1473 - 1476, XP032853915, DOI: 10.1109/NANO.2015.7388920
- BHAVANASI VENKATESWARLU ET AL: "Polarization Orientation, Piezoelectricity, and Energy Harvesting Performance of Ferroelectric PVDF-TrFE Nanotubes Synthesized by Nanoconfinement", ADVANCED ENERGY MATERIALS, vol. 4, no. 16, 1 November 2014 (2014-11-01), DE, pages 1400723, XP055831956, ISSN: 1614-6832, DOI: 10.1002/aenm.201400723

## Description

### Domaine technique

L'invention concerne le domaine de l'instrumentation d'un article à base de thermoplastique. Plus précisément, l'invention concerne un article comprenant des transducteurs à base de polymères piézoélectriques.

L'article selon l'invention peut être utilisé pour en mesurer un certain nombre de propriétés à surveiller ainsi que pour contrôler l'état et l'évolution de sa structure.

### Art antérieur

Le *Structural Health Monitoring* (SHM), ou contrôle de santé des structures a pour objectif de mesurer certaines propriétés physiques et / ou géométriques des matériaux utilisés dans une structure donnée. Il permet généralement de détecter et de prédire les variations de ces propriétés, ce qui peut notamment s'avérer utile pour évaluer les dommages et/ou le vieillissement des matériaux dans leur milieu opérationnel. Le SHM permet, selon certaines applications, de prévoir au moment opportun les actions de maintenance appropriées à mener.

Un processus de SHM comprend généralement : a) la prise de mesures dynamiques et échantillonnées, périodiquement ou de manière continue, à partir d'un réseau de capteurs, b) l'extraction des caractéristiques issues des mesures et, c) l'analyse statistique de ces caractéristiques afin de déterminer l'état de la structure.

Les céramiques de titanate de zirconium et de plomb (PZT) et les films de polyfluorure de vinylidène (PVDF) sont deux éléments piézoélectriques connus qui ont été utilisés comme transducteurs dans certaines applications SHM jusqu'à ce jour.

Les plaquettes PZT à constante piézoélectrique élevée possèdent à la fois une excellente sensibilité en tant que capteur et une forte capacité de déplacement en tant qu'actionneur. Elles ont néanmoins plusieurs désavantages. Elles sont tout d'abord rigides et cassantes : ceci empêche donc une utilisation sur des matériaux cintrés et/ ou soumis à des contraintes fortes. Elles sont également très lourdes, ce qui tend à alourdir la structure sur laquelle elles sont disposées. Elles sont de plus encombrantes de par leur taille de quelques millimètres d'épaisseur et de par la nécessité d'utiliser des câbles électriques pour les connecter. Enfin, elles contiennent souvent des métaux lourds, comme du plomb, ce qui peut rendre le recyclage d'articles en comprenant particulièrement complexe, voire impossible.

A contrario, les transducteurs à base de de films de PVDF ont pour avantage de présenter une flexibilité élevée, une faible densité, un faible coût de revient et peuvent être recyclés. Cependant, le PVDF possède une température d'utilisation maximum assez basse, limitée à 80 °C ou moins, ce qui limite ses possibilités d'utilisation en conditions opérationnelles et limite ses possibilités d'intégration à un matériau dont certaines propriétés doivent être mesurées.

Il est par exemple connu de Frias, C., et al. "Manufacturing and testing composite overwrapped pressure vessels with embedded sensors." Materials & Design 31.8 (2010): 4016-4022, la mise en place d'un système de contrôle de structure (SHM) au sein d'un récipient sous pression composite sur-emballé (en anglais *Composite Overwrapped Pressure Vessel,* également connu sous son acronyme COPV). Le système de contrôle comprend des transducteurs constitués d'une membrane de PVDF entre deux électrodes d'argent connectés par des fils électriques. Les transducteurs sont intercalés entre une enveloppe étanche (en anglais *liner*) et une structure de renfort composite, constituée de polypropylène renforcé de fibres de verre.

Il est également connu de Rim, Mi-Sun, et al. "Damage assessment of small-scale wind turbine blade using piezoelectric sensors." Sensors and Smart Structures Technologies for Civil, Mechanical, and Aerospace Systems 2012. Vol. 8345. International Society for Optics and Photonics, 2012, la mise en place d'un système de contrôle de structure (SHM) au sein d'un prototype de pâle pour éolienne. Le système de contrôle comprend des transducteurs constitués d'une membrane de PVDF entre deux électrodes métalliques. Les transducteurs sont disposés sur la surface du prototype.

La publication par BAEG KANG-JUN ET AL: "Low-voltage, high speed inkjet-printed flexible complementary polymer electronic circuits",ORGANIC ELECTRONICS, ELSEVIER, AMSTERDAM, NL, vol. 14, no. 5, 19 mars 2013 (2013-03-19), pages 1407-1418, divulgue les mélanges de polymères diélectriques à constante diélectrique élevée (P(VDF-TrFE)) avec du PMMA qui sont utilisés pour les dispositifs OFET à basse tension et les circuits complémentaires.

La publication par CHEN XIAOLIANG ET AL: "Nanowire-based flexible P(VDF-TrFE) nanogenerator for simultaneously harvesting mechanical and thermal energies", 2015 IEEE 15TH INTERNATIONAL CONFERENCE ON NANOTECHNOLOGY (IEEE-NANO), IEEE, 27 juillet 2015 (2015-07-27), pages 1473-1476, divulgue la fabrication d'un nanogénérateur flexible en P(VDF-TrFE) appliqué par centrifugation sur un substrat flexible en Kapton recouvert d'or.

La publication par BHAVANASI VENKATESWARLU ET AL: "Polarization Orientation, Piezoelectricity, and Energy Harvesting Performance of Ferroelectric PVDF-TrFE Nanotubes Synthesized by Nanoconfinement",ADVANCED ENERGY MATERIALS, vol. 4, no. 16, 1 juillet 2014 (2014-07-01), article 1400723, montre des performances de récolte des nanotubes ferroélectriques PVDF-TrFE alignés verticalement intégrés dans un gabarit AAO.

De tels réseaux de transducteurs de PVDF sont particulièrement encombrants et donc fastidieux à mettre en place. En outre, s'ils se retrouvent dans le volume de la structure à contrôler, cet encombrement les rend particulièrement invasifs, ce qui n'est pas souhaité puisqu'ils fragilisent alors la structure qu'ils sont censés contrôler.

### Objectifs de l'invention

La présente invention a pour objectif de palier au moins certains des inconvénients de l'art antérieur.

L'invention a notamment pour objectif, au moins selon certains modes de réalisation, de proposer un article composite comprenant au moins un système électronique avec des transducteurs à base de polymères piézoélectriques ayant une sensibilité améliorée.

L'invention a également pour objectif, au moins selon certains modes de réalisation, de proposer un article composite dont le système électronique soit peu invasif, c'est à dire perturbe le moins possible les performances de structure, notamment les propriétés mécaniques, de l'article qui ne présenterait pas ledit système électronique.

L'invention a également comme objectif de proposer, au moins selon certains modes de réalisation, un article composite dont le système électronique résiste à des températures élevées.

L'invention a aussi comme objectif de proposer, au moins selon certains modes de réalisation, un article composite dont le système électronique résiste aux contraintes s'exerçant sur l'article.

L'invention a enfin pour objectif, au moins selon certains modes de réalisation, de proposer un article composite facilement démontable, recyclable, et ne présentant pas de toxicité pour l'environnement et les êtres vivants.

### Résumé de l'invention

L'invention concerne un composite comprenant au moins un système électronique selon la revendication indépendante de dispositif 1.

Selon certains modes de réalisation, la matrice thermoplastique peut être une matrice (méth)acrylique, préférentiellement comprenant un homopolymère de méthacrylate de méthyle (MMA), ou un copolymère comprenant au moins 70% en poids de MMA, ou leur mélange.

Selon certains modes de réalisation, le polymère piézoélectrique peut avoir une proportion molaire en motif de répétition issu du TrFE de 16% à 35%, préférentiellement de 17% à 32%, de manière davantage préférée de 18% à 27%, et de manière extrêmement préférée de 19% à 22%, par rapport au nombre total de moles des motifs issus du VDF et du TrFE.

Selon certains modes de réalisation, le polymère piézoélectrique, peut notamment avoir une température de Curie strictement supérieure à 80°C, ou supérieure ou égale à 85°C, ou supérieure ou égale à 90°C, ou supérieure ou égale à 95°C, ou supérieure ou égale à 100°C, ou supérieure ou égale à 105°C, ou supérieure ou égale à 110°C, ou supérieure ou égale à 115°C, ou supérieure ou égale à 120°C, ou supérieure ou égale à 125°C, ou supérieure ou égale à 130°C, ou supérieure ou égale à 135°C, ou supérieure ou égale à 140°C, voire supérieure ou égale à 145°C.

Selon un premier mode de réalisation, le transducteur, ou la pluralité de transducteurs, comprend un film de polymère piézoélectrique.

Selon un deuxième mode de réalisation, le transducteur, ou la pluralité de transducteurs, est une fibre comprenant : une âme conductrice intérieure constituant une première électrode, un revêtement intermédiaire comprenant ledit au moins un polymère piézoélectrique adhérent à ladite âme conductrice et, un revêtement externe conducteur constituant une seconde électrode.

Selon un troisième mode de réalisation, le transducteur, ou la pluralité de transducteurs, et/ou les moyens de transmission du signal électrique, peuvent être obtenus par des méthodes d'impression électronique sur substrat.

La méthode d'impression est préférentiellement choisie parmi : le revêtement par centrifugation ( « spin-coating » ), la pulvérisation ou atomisation ( « spray coating » ), l'enduction notamment avec une barre ou un tire-film ( « bar coating » ), l'enduction avec une tête à fente (« slot die »), l'immersion ( « dip coating » ), l'impression à rouleaux ( « roll-to-roll printing »), l'impression en sérigraphie, l'impression en flexographie, l'impression en lithographie, l'électrospinning ou l'impression par jet d'encre.

Selon certains modes de réalisation, le polymère piézoélectrique du transducteur a une épaisseur de 1 micromètre (micron) à 50 micromètres (microns), préférentiellement de 2 micromètres (microns) à 25 micromètres (microns), et de manière extrêmement préférée de 5 à 15 micromètres (microns).

Selon certains modes de réalisation, l'article selon l'invention comprend une pluralité de transducteurs piézoélectriques formant un réseau.

Selon certains modes de réalisation, le système électronique est intégré à la matrice thermoplastique par un procédé de mise en œuvre dont la température ne dépasse pas la température de Curie du polymère piézoélectrique.

Selon certains modes de réalisation, l'article selon l'invention comprend un matériau de renfort. Le matériau de renfort étant préférentiellement un matériau constitué de fibres longues, notamment de fibres de verre ou de fibres de carbone. Selon certains modes de réalisation, le système électronique est intégré à la matrice thermoplastique par un procédé de polymérisation in-situ.

Selon certains modes de réalisation, l'article instrumenté peut être particulièrement un élément de structure ou une structure multicouche composite pour la distribution ou le stockage de l'hydrogène, un élément d'une éolienne, notamment une pâle d'éolienne, une barre d'armature pour béton, ou encore un élément de structure pour pack pour batteries.

Selon certains modes de réalisation, l'article selon l'invention est apte et destiné à être recyclé.

Selon un second aspect, l'invention concerne l'utilisation d'un système électronique pour assurer un contrôle du déroulement d'un procédé d'intégration (*Process Monitoring*) dudit système électronique à une matrice thermoplastique, le système électronique et la matrice thermoplastique étant destinés à former un article composite selon l'invention.

Selon un troisième aspect, l'invention concerne l'utilisation de l'article selon l'invention pour la mesure et/ou la surveillance de propriétés dudit article, notamment pour en assurer un contrôle de santé de structure (*Structural Health Monitoring*)*.*

Les inventeurs ont ainsi mis en œuvre un article instrumenté, dans lequel le(s) transducteur(s) sont particulièrement robustes, notamment dans des conditions de températures et de pressions contraignantes, ont une bonne sensibilité même dans des conditions contraignantes, sont facilement intégrables et sous des formes variées, à une matrice thermoplastique. L'article instrumenté comprenant des polymères thermoplastiques est également avantageusement apte et destiné à être recyclé.

### Liste des Figures

L'invention sera mieux comprise au regard des figures suivantes et de la description détaillée qui suit, de modes non limitatifs de l'invention :
[Figure 1] représente schématiquement un transducteur à base de film de P(VDF-TrFE) selon l'invention.
[Figure 2] représente schématiquement un transducteur sous forme de fibre piézoélectrique.
[Figure 3] représente schématiquement un réseau de fibres selon la Figure 2.
[Figure 4] représente schématiquement un réseau de transducteurs imprimés sur un substrat.
[Figure 5] représente schématiquement un moule pour un procédé par infusion.
[Figure 6] représente schématiquement un laminé thermoplastique composite au sein duquel sont intégrés des réseaux de capteurs, notamment des réseaux selon la Figure 4, pouvant être fabriqué selon un procédé d'imprégnation comme illustré en Figure 5.

### Description détaillée de l'invention

L'invention concerne un article composite comprenant au moins un système électronique, intégré en surface ou dans le volume d'une matrice thermoplastique.

Le terme « article composite » tel qu'il est utilisé ici, signifie au sens le plus général un matériau à plusieurs composantes, et notamment comme ici au moins un système électronique et une matrice thermoplastique. La matrice thermoplastique est la base d'un composite thermoplastique et comprend un matériau de renfort.

Le terme « intégré en surface » signifie que le système électronique, à tout le moins le transducteur piézoélectrique, est fixé directement sur la surface de l'article. Selon certains modes de réalisation, le système électronique, à tout le moins le transducteur piézoélectrique, est fixé à la surface de l'article au moyen d'un adhésif approprié. Bien que faisant partie de l'invention, ceci n'est pas un mode de réalisation préféré puisque le couplage acoustique avec le capteur est généralement assez faible. Selon certains modes de réalisation, le système électronique peut être soudé à la surface de l'article.

Le terme « intégré en volume » signifie que le système électronique, à tout le moins le transducteur piézoélectrique, est à l'intérieur du volume de l'article. Il peut être fixé ou noyé dans le volume de l'article. L'incorporation du transducteur directement dans le volume de l'article plutôt qu'en surface présente certains avantages comme un meilleur couplage acoustique.

Le terme « thermoplastique », ou polymère thermoplastique, désigne un matériau généralement solide à température ambiante, pouvant être semi-cristallin ou amorphe, et qui se ramollit lors d'une augmentation de température, en particulier après passage de sa température de transition vitreuse (Tg) et s'écoule à plus haute température lorsqu'il est amorphe, ou pouvant présenter une fusion franche au passage de sa température dite de fusion (Tf) lorsqu'il est semi-cristallin, et qui redevient solide lors d'une diminution de température en dessous de sa température de cristallisation (pour un semi-cristallin) et en dessous de sa température de transition vitreuse (pour un amorphe).

La Tg et la Tf sont déterminées par analyse calorimétrique différentielle (DSC) selon la norme ISO11357-2 :2013 et ISO11357-3 :2013 respectivement.

Les polymères thermoplastiques, contrairement aux polymères thermodurcissables qui sont infusibles et non transformables, peuvent être recyclés.

Les polymères thermoplastiques entrant dans la constitution de la matrice thermoplastique, peuvent être choisis parmi :
- les polymères et copolymères de la famille des acryliques comme les polyacrylates ou les polyméthacrylates, et plus particulièrement le polyméthacrylate de méthyle (PMMA) ou ses dérivés,
- les polymères et copolymères de la famille des polyamides (PA) aliphatiques, cycloaliphatiques ou des PA semi-aromatiques (encore dénommés polyphtalamides (PPA)),
- les polyurées, en particulier aromatiques,
- les polymères et copolymères de la famille des polyaryléther cétones (PAEK) comme le poly(étheréthercétone) (PEEK), ou les poly(aryléthercétonescétones) (PAEKK) comme le poly(éthercétonecétone) (PEKK) ou leurs dérivés,
- les polyéther-imides (PEI) aromatiques,
- les polyarylsulfures, en particulier les polyphénylène sulfures (PPS),
- les polyarylsulfones, en particulier les polyphénylène sulfones (PPSU),
- les polyoléfines, en particulier le polypropylène (PP);
- l'acide polylactique (PLA),
- l'alcool polyvinylique (PVA),
- les polymères fluorés, en particulier le poly(fluorure de vinylidène) (PVDF), ou le polytétrafluoroéthylène (PTFE) ou le polychlorotrifluoroéthylène (PCTFE), et leurs mélanges.

Dans des modes de réalisation préférés, la matrice thermoplastique peut notamment être une matrice (méth)acrylique, et notamment du PMMA. De telles matrices thermoplastiques sont particulièrement avantageuses. En effet, il est connu la mise en forme de telles matrices, notamment la mise en forme de composites thermoplastiques intégrant un matériau fibreux, à des températures « basses », c'est-à-dire notamment à des températures inférieures ou égale à 145°C, ou inférieure ou égale à 135°C, ou inférieure ou égale à 130°C, ou inférieure ou égale à 120°C, ou inférieure ou égale à 110°C, ou inférieure ou égale à 100°C, ou inférieure ou égale à 90°C. En outre, il est connu que de telles matrices sont recyclables.

Le terme « (méth)acrylique », dans le présent contexte, désigne tous les types de monomères acryliques et méthacryliques.

Le terme « PMMA », dans le présent contexte, désigne un homopolymère ou un copolymère de méthacrylate de méthyle (MMA), ou leurs mélanges. Selon un mode de réalisation, l'homo- ou le copolymère de méthacrylate de méthyle (MMA) comprend au moins 70 %, de préférence au moins 80 %, avantageusement au moins 90 % et plus avantageusement au moins 95 % en poids de méthacrylate de méthyle.

Selon certains modes de réalisation, le PMMA peut être un mélange d'au moins un homopolymère et d'au moins un copolymère de MMA.

Selon certains modes de réalisation, le PMMA peut être un mélange d'au moins deux homopolymères.

Selon certains modes de réalisation, le PMMA peut être un mélange de deux copolymères de MMA ayant un poids moléculaire moyen différent.

Selon certains modes de réalisation, le PMMA peut être un mélange d'au moins deux copolymères de MMA ayant une composition de monomères différente.

Le copolymère de méthacrylate de méthyle (MMA) peut comprendre de 70 % à 99,7 % en poids de méthacrylate de méthyle et de 0,3 à 30 % en poids d'au moins un autre monomère contenant au moins une insaturation éthylénique qui peut être copolymérisée avec le méthacrylate de méthyle. Ces autres monomères sont bien connus, et on peut notamment mentionner les acides acrylique et méthacrylique et les (méth)acrylates d'alkyle dans lesquels le groupe alkyle contient de1 à 12 atomes de carbone. En tant qu'exemples, il peut être mentionné l'acrylate de méthyle et le (méth)acrylate d'éthyle, de butyle ou de 2-éthylhexyle. De préférence, le comonomère est un acrylate d'alkyle dans lequel le groupe alkyle contient de 1 à 4 atomes de carbone.

Selon des modes de réalisation préférés, le copolymère de méthacrylate de méthyle (MMA) peut comprendre de 80 % à 99,9 %, avantageusement de 90 % à 99,9 % et plus avantageusement de 90 % à 99, 9 % en poids de méthacrylate de méthyle, et de 0, 1 % à 20 %, avantageusement de 0,1 % à 10 % et plus avantageusement de 0,1 % à 10 % en poids d'au moins un monomère contenant au moins une insaturation éthylénique qui peut être copolymérisée avec le méthacrylate de méthyle. De préférence, le co-monomère est choisi parmi l'acrylate de méthyle, l'acrylate d'éthyle, et leurs mélanges.

La masse moléculaire moyenne en poids de la matrice thermoplastique utilisée pour la fabrication d'un article est généralement élevée. La masse moléculaire en poids est préférentiellement supérieure à 50000 g/mol, et de manière encore préférée supérieure à 100000g/mol, telle que mesurée par chromatographie par perméation de gel.

Le polymère piézoélectrique dudit au moins un transducteur est essentiellement constitué, ou constitué, des motifs de répétition issus du fluorure de vinylidène (VDF) et du trifluorure de vinylidène (TrFE), la proportion molaire du motif issu du TrFE étant de 15% à 50% par rapport au nombre total de moles des motifs issus du VDF et du TrFE.

Le copolymère piézoélectrique est un thermoplastique. Il peut donc être recyclé facilement et n'est pas source de métaux lourds, comme le sont les céramiques piézoélectriques.

Le polymère cristallise presque exclusivement sous phase beta et possède ainsi d'excellentes propriétés ferroélectriques. A contrario, en deçà d'une proportion molaire de 15% en motif issu du TrFE ou au-delà d'une proportion molaire de 50% en motif issu du TrFE, la phase cristalline cristallise beaucoup moins bien sous forme beta (ferroélectrique).

Selon des modes de réalisation préférés, le polymère piézoélectrique a une proportion molaire en motif de répétition issu du TrFE de 16% à 35%, préférentiellement de 17% à 32%, et de manière davantage préférée de 18% à 27%, et de manière extrêmement préférée de 19% à 22%, par rapport au nombre total de moles des motifs issus du VDF et du TrFE.

Le polymère piézoélectrique peut notamment avoir une proportion molaire en motif de répétition issu du TrFE d'environ 20% par rapport au nombre total de moles des motifs issus du VDF et du TrFE.

Dans les gammes de valeurs précitées, avantageusement dans les gammes de valeurs préférées, le polymère piézoélectrique utilisé dans l'article selon l'invention présente, au moins certaines des caractéristiques suivantes :
- une large bande passante (10 Hz - 50 MHz), notamment en comparaison avec des capteurs à base de céramiques piézoélectriques ;
- une constante de tension g33 élevée, grâce à une permittivité relative εᵣ faible, notamment en comparaison avec des céramiques piézoélectriques ;
- une relative souplesse, permettant une intégration sur des surfaces courbes et/ou soumises à de fortes contraintes mécaniques, ce qui peut être difficilement réalisé avec des céramiques piézoélectriques ;
- une impédance acoustique faible au regard des céramiques piézoélectriques, proche de celle des matériaux polymères : ceci permet de s'affranchir de l'utilisation d'une couche d'adaptation acoustique (« *matching layer »*) à l'interface transducteur/matrice thermoplastique, généralement nécessaire pour les céramiques piézoélectriques ;
- une propriété de non-résonance, c'est-à-dire que les signaux sont reçus avec une sensibilité plus ou moins égale sur une large gamme de fréquences, contrairement aux capteurs céramiques piézoélectriques qui sont généralement de type résonnant avec une sensibilité élevée dans leurs largeurs de bande de résonance ;
- une stabilité thermique élevée, notamment comparée à celle du PVDF polarisé qui perd ses propriétés électroactives au-delà de 80°C ;
- une sensibilité élevée, notamment comparée à celle du PVDF polarisé, grâce à une valeur de coefficient de couplage électro-acoustique kt élevée.

Le copolymère piézoélectrique dans les gammes de proportions en VDF et en TrFE précitées est de plus soluble dans une plus grande variété de solvants que ne l'est le PVDF, ce qui permet de le formuler sous forme d'encre et de l'utiliser facilement dans des techniques d'impression électronique avec facilité et flexibilité.

Selon certains modes de réalisation, le polymère piézoélectrique comprend en plus des motifs de répétition issus du VDF et du TrFE jusqu'à 1% molaire d'au moins un motif de répétition issu d'un autre monomère que le VDF et le TrFE, l'autre monomère étant choisi dans la liste constituée de :
un dialkylester d'acide vinylphosphonique, notamment le diméthylester d'acide vinylphosphonique ou l'acide vinylphosphonique ;
un monomère acrylique ou méthacrylique, notamment l'acide acrylique, l'acide méthacrylique, l'acide (2-trifluorométhyl) acrylique, l'hydroxyéthyl acrylate, l'hydroxyéthyl méthacrylate, l'hydroxypropyl acrylate, l'hydroxypopyl méthacrylate, l'hydroxyéthylhexyl acrylate, ou l'hydroxyethyl hexyl méthacrylate ; un autre monomère fluoré, notamment le fluorure de vinyle (VF), le tétrafluoroéthylène (TFE), un chlorofluoroéthylène (CFE), un chlorodifluoroéthylène, le chlorotrifluoréthylène (CTFE), le dichlorodifluoroéthylène, un trichlorofluoroéthylène, l'hexafluoropropylène (HFP), un trifluoropropène, un tétrafluoropropène, un chloro-trifluoropropène, l'hexafluoroisobutylène, le perfluorobutyléthylène, ou un pentafluoropropène, un perfluoroéther, notamment un perfluoroalkylvinyléther ; et,
un mélange de ceux-ci.

Selon certains modes de réalisation, le polymère piézoélectrique est constitué des motifs de répétition issus du VDF et du TrFE.

La température de Curie correspond à une transition de structure cristalline ferroélectrique -> paraélectrique (FE -> PE), appelée transition de Curie, correspondant à une dépolarisation brutale des domaines ferroélectriques macroscopiques. Elle peut être déterminée par exemple par Calorimétrie Différentielle à Balayage (DSC), comme la température du maximum de l'endotherme correspondant à cette transition, lors du premier ou second chauffage, préférentiellement lors du second chauffage, à 10°C/min, ou par Spectroscopie Diélectrique, comme la température correspondant au maximum du pic de permittivité diélectrique lors du chauffage à 10°C/min à une fréquence de 1kHz.

La température de Curie du polymère piézoélectrique peut être ajustée en fonction de la composition en VDF et TrFE du polymère : plus la proportion de fluorure de vinylidène est importante plus la température de Curie est élevée. Par exemple, il est connu que la température de Curie du P(VDF-TrFE) (80:20) (mol:mol) est de : 137°C. Ainsi, un transducteur comprenant du P(VDF-TrFE) (80:20) (mol:mol), pourra être mis en œuvre à l'état polarisé dans l'article selon l'invention et/ou être utilisé à une température de fonctionnement pouvant atteindre jusqu'à environ 135°C. A titre de comparaison, la température de Curie du P(VDF-TrFE) (84:16) (mol:mol) est de : 150°C alors que celle du P(VDF-TrFE) (65 :35) (mol:mol) est de : 84°C. En fonction du besoin, notamment en fonction des conditions opérationnelles d'utilisation de l'article, la composition du polymère piézoélectrique peut être ajustée de telle sorte à ce que sa température de Curie soit strictement supérieure à 80°C, ou supérieure ou égale à 85°C, ou supérieure ou égale à 90°C, ou supérieure ou égale à 95°C, ou supérieure ou égale à 100°C, ou supérieure ou égale à 105°C, ou supérieure ou égale à 110°C, ou supérieure ou égale à 115°C, ou supérieure ou égale à 120°C, ou supérieure ou égale à 125°C, ou supérieure ou égale à 130°C, ou supérieure ou égale à 135°C, ou supérieure ou égale à 140°C, voire supérieure ou égale à 145°C.

Selon des modes de réalisation préférés, la matrice thermoplastique est choisie de telle sorte à ce que la température de mise en forme de la matrice pour intégrer le transducteur soit inférieure à la température de Curie du polymère piézoélectrique. Dans ces modes de réalisation, le transducteur peut être intégré déjà polarisé, être le cas échéant utilisé pour contrôler le processus d'intégration du transducteur ou du réseau de transducteur au sein de la matrice thermoplastique, et conservera sa polarisation une fois l'article mis en forme. Comme déjà décrit, la matrice thermoplastique peut notamment être une matrice (méth)acrylique, et notamment du PMMA.

Selon certains modes de réalisation, le polymère piézoélectrique a une masse molaire moyenne en masse de 100 000 g/mol à 2 000 000 g/mol, de préférence de 300 000 g/mol à 1 500 000 g/mol, et de manière extrêmement préférée de 400 000 à 700 000 g/mol.

Selon certains modes de réalisation, le polymère piézoélectrique est un polymère à structure homogène, préférentiellement un copolymère statistique.

Selon certains modes de réalisation, les motifs issus du VDF dans le polymère piézoélecrique sont issus, au moins en partie, de VDF biosourcé.

Le système électronique adapté pour le contrôle de santé de structure comprend au moins un transducteur et des moyens de transmission électrique. Un transducteur est formé par au moins le polymère piézoélectrique interposé entre deux électrodes.

Trois modes d'utilisation des transducteurs peuvent être considérés :
- émission acoustique ;
- impédance électromécanique ; et,
- émission ultrasonique.

Le transducteur peut être utilisé en tant que récepteur, c'est-à-dire de manière passive, ou en tant qu'actionneur, c'est-à-dire de manière active. La fonction du transducteur n'est à priori pas prédéterminée et il est donc envisageable de le faire fonctionner à certains moments comme capteur et à d'autres comme actionneur.

Selon certains modes de réalisation, le transducteur est un transducteur de type « interdigité », c'est-à-dire que les électrodes sont en forme de peignes et s'entrecroisent.

Le système électronique selon l'invention comprend avantageusement une pluralité de transducteurs, formant un réseau de transducteurs plus ou moins interconnectés entre eux. Plus précisément, certains transducteurs peuvent être placés en communication électrique les uns aux autres en partageant un même chemin de transmission électrique. De tels réseaux, intégrés à la surface et/ou dans le volume de l'article, sont capables de détecter et / ou transmettre des ondes mécaniques à l'intérieur de la structure de l'article composite afin de détecter la présence d'un dommage ou de sonder la structure de l'article.

Les capteurs piézoélectriques peuvent par exemple détecter et mesurer la propagation d'ondes au sein de l'article (vitesse de propagation, intensités de l'onde, ...). L'onde mesurée peut, dans certaines situations, avoir générée par un actionneur produisant une onde mécanique de faible intensité et de fréquence connue dans la structure (détection active). L'onde mesurée peut, dans d'autres situations, avoir été générée par un impact, ou une source interne telle qu'une fissure sur la structure (détection passive).

Les capteurs piézoélectriques peuvent par exemple également mesurer des déformations, des variations de contraintes ou de températures, etc.

Les moyens de transmission électrique permettent de conduire un signal électrique vers et depuis chacun des transducteurs. Ils peuvent être constitués par exemple de fils électriques ou alternativement de pistes conductrices imprimées sur un substrat (voir plus loin techniques d'impression électronique).

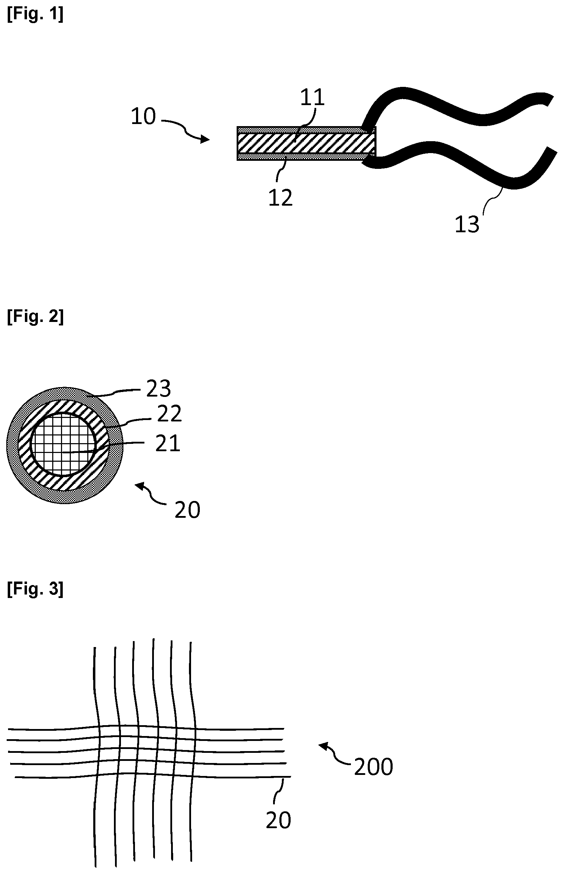

Selon un premier mode de réalisation, en référence à la Figure 1, le transducteur 10 peut être un film de polymère piézoélectrique 11 interposé entre deux électrodes 12, tels les transducteurs utilisés pour le COPV ou pour le prototype d'éolienne décrits dans l'art antérieur. En général, la surface occupée par un tel transducteur est de l'ordre de 0,1 à 100 cm². Des câbles électriques 13 soudés aux électrodes assurent la transmission du signal électrique. Bien que faisant partie de l'invention, ce mode de réalisation n'est pas un mode de réalisation préféré du fait de l'encombrement engendré par les câbles électriques. Ce mode de réalisation est encore moins préféré lorsque le transducteur, ou le réseau de transducteurs, est intégré dans le volume de l'article du fait du caractère invasif des câbles électriques. Néanmoins, ce mode de réalisation reste envisageable notamment lorsque le(s) transducteur(s) est (sont) disposé(s) à la surface de l'article.

Il peut également être imaginé que le transducteur présente la structure du premier mode de réalisation (film et électrodes) sous forme de ruban allongé, ce qui se rapproche du second mode de réalisation présenté ci-dessous.

Selon un second mode de réalisation, le transducteur peut être une fibre piézoélectrique continue. En référence à la figure 2 représentant une coupe transverse, la fibre 20 comprend une âme métallique 21 constituant une première électrode. L'âme métallique peut par exemple être faite de cuivre, de platine, d'acier inoxydable, de molybdène, ou d'un de leurs alliages. La fibre comprend un revêtement intermédiaire 22 comprenant ledit polymère piézoélectrique adhérent à l'âme conductrice. La fibre comprend enfin un revêtement conducteur 23 recouvrant, au moins en partie, le revêtement intermédiaire et constituant une seconde électrode. La fibre peut avoir un diamètre moyen allant de 500 micromètres à 5 micromètres, et de préférence de 400 micromètres à 20 micromètres.

Un procédé de fabrication de telles fibres a notamment été décrit en détails dans WO 2020/128230 A1.

Bien que la fibre représentée en Figure 2 est une fibre continue de section circulaire, il peut également être imaginé des modes de réalisation où la fibre a une section de forme différente, notamment rectangulaire.

Selon certains modes de réalisation, plusieurs fibres peuvent être assemblées entre elles de sorte à former un réseau de fibres. Le réseau de fibres piézoélectrique peut par exemple former un quadrillage en deux dimensions, tel celui schématisé à la Figure 3, voire un quadrillage en trois dimensions.

La fibre ou le réseau de fibres, peut être associé à un matériau de renfort fibreux, comme il sera vu plus loin, de forme unidimensionnelle, ou bidimensionnelle ou encore tridimensionnelle. La fibre, ou le réseau de fibres, peut notamment être intégré à un mat de filaments continus, des tissus, des feutres ou des non-tissés qui peuvent être sous la forme de bandes, nappes, tresses, mèches de matériaux de renfort fibreux.

Selon certains modes de réalisation, une fibre piézoélectrique ou le plus souvent un réseau de fibres piézoélectriques peuvent être incluses à un tissé ou un non-tissé de fibres, par exemple au sein d'un matériau de renfort. Le réseau de fibres piézoélectrique peut par exemple former un quadrillage en deux dimensions, tel celui schématisé à la Figure 3, voire en trois dimensions.

Selon un troisième mode de réalisation, préféré, le transducteur et/ou les moyens de transmission électrique peuvent être obtenus par des techniques d'électronique imprimée, c'est-à-dire par application de compositions aptes et destinées à former les constituants du transducteur sur un substrat thermoplastique, notamment par étalement par des moyens discrets ou continus. Ce mode de réalisation est particulièrement avantageux car il permet la plus grande liberté de forme et de design.

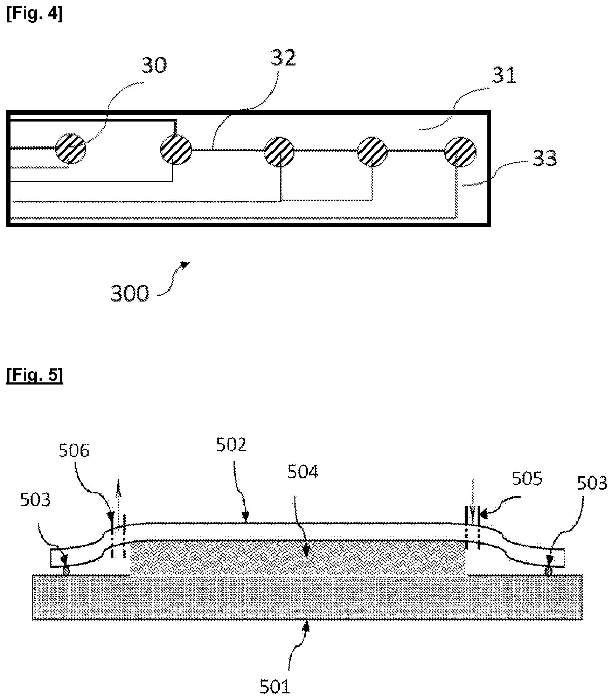

En référence à la Figure 4, un circuit 300 comprend une pluralité de transducteurs 30 formant un réseau, reliés de manière indépendante, ou en série, ou en parallèle par des pistes conductrices 32, 33, imprimés sur un substrat 31. Bien que le substrat soit ici représenté comme un film continu, selon certains modes de réalisation, certaines zones ne supportant ni les transducteurs, ni les pistes électriques peuvent être découpées, par exemple par laser, de manière à limiter l'encombrement et le caractère invasif du circuit dans le volume de l'article.

Le circuit représenté en Figure 4 ne représente pas nécessairement un cas réel, mais permet d'exemplifier différents agencements de transducteurs entre eux au sein d'un réseau de transducteurs.

Le dépôt peut être effectué notamment par revêtement par centrifugation ( « spin-coating » ), par pulvérisation ou atomisation ( « spray coating » ), par enduction notamment avec une barre ou un tire-film ( « bar coating » ), par enduction avec une tête à fente (« slot die »), par immersion ( « dip coating » ), par impression à rouleaux ( « roll-to-roll printing »), par impression en sérigraphie, par impression en flexographie, par impression en lithographie, par électrospinning ou par impression par jet d'encre.

Selon certains modes de réalisation, le substrat peut être de même nature chimique que la matrice thermoplastique. Par exemple, dans le cas où la matrice thermoplastique est un PMMA, le substrat peut également être un PMMA.

Des substrats usuels pour les transducteurs de polymères piézoélectriques sont notamment : le polytéréphtalate d'éthylène (PET), le polynaphtalate d'éthylène (PEN), le papier, le PMMA, le polycarbonate (PC) ou encore les polyamides.

Le copolymère piézoélectrique dans les gammes de proportions en VDF et en TrFE selon l'invention est utilisable avec une grande variété de véhicules liquides, contrairement au PVDF. Le véhicule liquide peut être choisi, de manière non limitative, parmi les esters tels que l'acétate d'éthyle, l'acétate de propyle, l'acétate de butyle, le propionate d'isobutyle, le propylène glycol monométhyl éther, le lactate de méthyle, le lactate d'éthyle et la gamma-butyrolactone ; les alkyl phosphates tels que le triéthylphosphate ; les alkyl carbonates tels que le diméthyl carbonate ; les cétones telles que l'acétone, l'acétylacétone, la méthylisobutyl cétone, la 2-butanone, la 2-pentanone, la 2-heptanone, la 3-heptanone, la cyclopentanone et la cyclohexanone ; les amides tels que le diméthyl formamide (DMF) ou le diméthylacétamide (DMAc) ; les solvants soufrés tels que le diméthylsulfoxyde (DMSO) ; les solvants halogénés tels que le chloroforme, et les alcanes halogénés ; et leurs mélanges. On préfère dans cette invention utiliser la 2- butanone, la cyclohexanone, le diméthylsulfoxyde, le propylène glycol monométhyl éther, le triéthylphosphate, le diméthylacétamide, et leurs mélanges Le dépôt d'électrodes peut être mis en oeuvre par évaporation ou pulvérisation ou impression, de métal, d'oxyde indium-étain, d'une couche de polymère conducteur, d'encre conductrice à base d'argent, de nanofils d'argent, de polymères conducteurs tel que le PEDOT:PSS, ou de graphène.

Bien que cela n'a pas été représenté sur schéma des trois modes de réalisation discutés ci-dessus (cf. Figure 1, Figure 2 et Figure 4), il est envisageable de recouvrir, au moins en partie, le(s) transducteur(s), et le cas échéant les pistes conductrices, d'une couche protectrice constituée d'un matériau isolant. Cela permet notamment, quand cela est nécessaire, d'assurer une protection contre toute matière polluante environnante afin notamment d'éviter les court-circuits électriques et pour améliorer la stabilité et la fiabilité opérationnelles. De préférence, le matériau isolant est un thermoplastique. Selon certains modes de réalisation, le matériau isolant peut être de même nature chimique que la matrice thermoplastique. Le matériau isolant peut notamment être le PMMA.

Pour être utilisé en tant que transducteur, le polymère piézoélectrique doit être polarisé selon des méthodes connues en soi : par polarisation contact en appliquant une tension continue ou alternative ou sans contact en utilisant l'effet Corona. La polarisation peut être réalisée de plusieurs façons, soit au cours de la fabrication du transducteur lui-même, soit une fois les différents éléments constitutifs du transducteur assemblés.

Selon certains modes de réalisation, le transducteur, ou le réseau de transducteurs, est polarisé avant d'être intégré à la matrice thermoplastique.

Selon certains modes de réalisation, le transducteur, ou le réseau de transducteurs, est polarisé après avoir été intégré à la matrice thermoplastique.

Il peut également être imaginé de polariser les transducteurs avant leur intégration à la matrice thermoplastique pour en vérifier l'intégrité, puis de les polariser à nouveaux une fois le(s) transducteur(s) intégré(s) si ce(s) dernier(s) a/ont été soumis à des conditions de températures ayant provoqué leur dépolarisation. L'avantage du copolymère piézoélectrique utilisé dans les transducteurs selon l'invention est qu'il peut être repolarisé après dépolarisation due à un traitement thermique, contrairement au PVDF.

Selon des modes de réalisation avantageux, le transducteur, ou le réseau de transducteurs, est polarisé avant intégration dans la matrice thermoplastique et reste fonctionnel après avoir été intégré à la matrice thermoplastique. Ceci est notamment possible si la température au cours du procédé d'intégration ne dépasse pas la valeur de la température de Curie.

L'article selon l'invention peut, selon certains modes de réalisation au moins, comprendre un matériau de renfort, notamment un matériau fibreux. Le matériau fibreux peut avoir différentes formes (unidimensionnelle, bidimensionnelle ou tridimensionnelle). Le matériau fibreux comprend généralement un assemblage d'une ou de plusieurs fibres. Il peut se présenter sous la forme de fibres, de mèches unidirectionnelles ou d'un mat de filaments continus, des tissus, des feutres ou des non-tissés qui peuvent être sous la forme de bandes, nappes, tresses, mèches ou pièces.

La forme unidimensionnelle correspond à des fibres longues linéaires. Les fibres peuvent être discontinues ou continues. Les fibres peuvent être agencées de façon aléatoire ou parallèles les unes aux autres, sous la forme d'un filament continu. Une fibre est définie par son rapport de longueur, qui est le rapport entre la longueur et le diamètre de la fibre. Les fibres généralement utilisées sont des fibres longues ou des fibres continues. Les fibres ont un rapport de longueur d'au moins 1000, de préférence d'au moins 1500, plus préférablement d'au moins 2000, avantageusement d'au moins 3000 et plus avantageusement d'au moins 5000, encore plus avantageusement d'au moins 6000, encore plus avantageusement d'au moins 7500 et de manière préférée entre toutes d'au moins 10 000.

La forme bidimensionnelle correspond à des mats fibreux, ou des renforts, ou des faisceaux de fibres non-tissés ou tissés, qui peuvent également être tressés. Même si la forme bidimensionnelle a une certaine épaisseur et, par conséquent, en principe une troisième dimension, elle est considérée ici comme étant bidimensionnelle

La forme tridimensionnelle correspond par exemple à des mats fibreux ou des renforts non tissés ou des faisceaux de fibres ou leurs mélanges empilés ou pliés, un assemblage de la forme bidimensionnelle dans la troisième dimension.

Les origines du matériau fibreux peuvent être naturelles ou synthétiques. En tant que matériau naturel, on peut mentionner des fibres végétales, des fibres de bois, des fibres animales ou des fibres minérales.

Des fibres naturelles sont, par exemple, le sisal, le jute, le chanvre, le lin, le coton, les fibres de noix de coco et les fibres de banane. Des fibres animales sont, par exemple, la laine ou les poils.

En tant que matériau synthétique, il peut être mentionné des fibres polymères choisies parmi des fibres de polymères thermodurcissables, des polymères thermoplastiques ou des mélanges de ceux-ci.

Les fibres polymères peuvent être constituées de polyamide (aliphatique ou aromatique), polyester, alcool polyvinylique, polyoléfines, polyuréthanes, polychlorure de vinyle, polyéthylène, polyesters insaturés, résines époxy et esters vinyliques.

Les fibres minérales peuvent également être choisies parmi des fibres de verre, en particulier de type E, R ou S2, des fibres de carbone, des fibres de bore ou des fibres de silice.

De préférence, le matériau fibreux est choisi parmi des fibres minérales. Plus préférablement, le matériau fibreux est choisi parmi des fibres de verre ou des fibres de carbone.

Les fibres du matériau fibreux ont avantageusement un diamètre compris entre 0,005 µm et 100 µm, de préférence entre 1 µm et 50 µm, plus préférablement entre 5 µm et 30 µm, et avantageusement entre 10 µm et 25 µm.

De préférence, les fibres du matériau fibreux de la présente invention sont choisies parmi des fibres continues (ce qui signifie que le rapport de longueur ne s'applique pas comme pour les fibres longues) pour la forme unidimensionnelle, ou parmi les fibres longues ou continues pour la forme bi- ou tridimensionnelle du matériau fibreux.

Selon certains modes de réalisation, l'article composite comprend un matériau fibreux et est obtenu par imprégnation. Le terme « imprégnation » tel qu'il est utilisé, désigne la pénétration de liquides monomères, oligomères ou polymères ou de mélanges de ceux-ci dans un assemblage de fibres. Le système électronique peut alors être disposé à des endroits préétablis avec un couplage optimum dans le volume de l'article au cours de l'étape d'imprégnation. Ce mode de réalisation est illustré ci-après avec une matrice PMMA.

L'article composite peut, selon certains modes de réalisation, comprendre d'autres charges que le matériau de renfort et/ou des additifs fonctionnels. Parmi les additifs fonctionnels, on peut notamment inclure un ou des tensioactifs, stabilisants UV, stabilisants thermiques, stabilisants à la lumière, modifiants choc, plastifiants, agents expansifs et/ou agents biocides, des particules conductrices thermiquement et/ou électriquement, des colorants, des agents ignifugeants, des retardateurs de flammes, etc. Les charges peuvent notamment être des charges minérales telles que l'alumine, la silice, le carbonate de calcium, le dioxyde de titane, les billes de verre, le noir de carbone, le graphite le graphène et les nanotubes de carbone.

### Utilisation en SHM

Des capteurs piézoélectriques peuvent être utilisés pour identifier des chocs et/ou des mécanismes d'endommagement. On considère qu'il existe quatre principaux mécanismes d'endommagement identifiables dans les composites thermoplastiques, c'est-à-dire des composites comprenant une matrice thermoplastique et un matériau de renfort, par leur «signature» d'émission acoustique : (i) la fissuration de la matrice thermoplastique, (ii) le décollement interfacial, (iii) le frottement fibre / matrice, l'arrachement de la fibre et (iv) la rupture de la fibre. Parmi ces quatre mécanismes, le premier concerne les thermoplastiques de manière général, comprenant ou non un matériau de renfort. La plupart de ces dommages se produisent sous les surfaces supérieures et sont à peine visibles. Ils peuvent gravement dégrader les performances des composites et doivent être identifiés à temps pour éviter des défaillances structurelles catastrophiques.

Les modes de défaillance des composites génèrent des ondes acoustiques dans des gammes de fréquences spécifiques: micro-fissuration de la matrice (50-170 kHz), arrachement de fibre (170-220 kHz), découplage / délaminage (220-300 kHz) et rupture de fibre (300 à 500 kHz). Chaque dommage peut être classé en fonction de la bande de fréquence dominante extraite des signaux des capteurs piézoélectriques.

Alternativement et/ou en complément, des ondes acoustiques peuvent également être générées par des transducteurs actifs afin de donner des informations périodiques sur l'état de la structure du composite.

Enfin, les capteurs piézoélectriques peuvent aussi mesurer des déformations, des variations de contraintes, des variations températures, etc.

Un système de SHM comprend généralement des moyens d'acquisition et de traitement du signal, comme par exemple un circuit d'atténuation pour gérer les amplitudes des signaux électriques générés par les capteurs, des éléments filtrants pour isoler différentes fréquences gammes des signaux électriques, un analyseur pour analyser les signaux filtrés à différentes fréquences, un microprocesseur, etc , afin de pouvoir acquérir et analyser le signal électrique transmis par les capteurs. Selon certains modes de réalisation, certains au moins de ces éléments d'acquisition et/ou de traitement peuvent faire partie du système électronique intégré à l'article composite. Selon certains modes de réalisation, certains ces éléments ne font pas partie du système électronique intégré et sont externes à l'article composite.

### Articles

L'article selon l'invention peut être utilisé dans de nombreuses applications. Il peut notamment être utilisé dans le secteur des transports (pièce s'automobile, pièce de bateau, pièce de train, pièce d'avion ou d'hélicoptère, pièce de vaisseau spatial ou fusée, etc.), dans le secteur de l'énergie (pièce pour pack de batteries, pièce pour éolienne, pièce pour module photovoltaïque, etc.) une pièce de construction ou de bâtiment (barre d'armature), une pièce d'appareil électrique ou électronique (pièce de téléphone, pièce d'ordinateur, etc.)

Les articles composites selon l'invention peuvent notamment être des éléments de structure ou des structures multicouches composites pour la distribution ou le stockage de l'hydrogène, des éléments de structure pour éolienne, comme des pâles d'éoliennes, des barres d'armatures pour béton, ou encore des éléments de structures ou des structures de packs pour batteries.

Par « structure multicouche » il faut entendre par exemple un réservoir, un tuyau ou tube, comprenant ou constitué de plusieurs couches, notamment de deux couches. Le système électronique peut être intégré dans le volume ou en surface d'une des couches. Il peut notamment être utilisé pour mesurer des variations de températures, des variations de contraintes et l'état de la structure au cours des différentes charges et décharge en dihydrogène.

Par « barre d'armature », il faut entendre une barre de renfort qui est utilisée en tant que dispositif de tension dans du béton armé et des structures en maçonnerie armée pour renforcer et soutenir le béton sous tension. Etant donnée la forme de telles barres, le système électronique doit se présenter sous une forme allongée, et peut notamment comprendre des fibres piézoélectriques ou des languettes imprimées de transducteurs. Un procédé de fabrication de telles barres en composites PMMA est divulgué dans FR3087203 A1. Le système électronique peut notamment permettre d'évaluer les contraintes s'exerçant au sein des barres de renfort et leur état de fatigue dans le temps.

L'article selon l'invention peut également être une pièce de structure pour éolienne, notamment une pâle d'éolienne. Un réseau de capteurs peut notamment être déployé sur une grande longueur. Le système électronique est avantageusement intégré dans le volume de sorte à ne pas interférer avec l'aérodynamisme de la pâle.

L'article selon l'invention peut aussi être utilisé dans un pack de batteries pour permettre d'identifier les anomalies de certaines des cellules (températures excessives, détérioration, etc).

### Procédé de fabrication d'un article composite selon l'invention

Le procédé comprend :
- une étape de fourniture d'un système électronique tel que décrit dans la section précédente ;
- une étape de mise en forme de la matrice thermoplastique de telle sorte à ce que le système électronique, et optionnellement un matériau de renfort ou d'autres charges, y soit (soient) intégrés.

Les procédés de mise en forme usuels des matériaux thermoplastiques, le cas échéant de composites thermoplastiques, peuvent généralement être utilisés.

Avantageusement, la température de mise en œuvre de la matrice thermoplastique ne dépasse pas la température de Curie du polymère piézoélectrique. La température de mise en œuvre de la matrice thermoplastique peut ainsi être inférieure ou égale à 145°C, ou inférieure ou égale à 135°C, ou inférieure ou égale à 130°C, ou inférieure ou égale à 120°C, ou inférieure ou égale à 110°C, ou inférieure ou égale à 100°C, ou inférieure ou égale à 90°C.

Ceci permet l'intégration du système électronique comprenant de(s) transducteur(s) déjà polarisés. Bien que possible et envisageable, cela permet d'éviter la polarisation des transducteurs une fois intégrés à la matrice.

L'intégration du système électronique avec des transducteurs déjà polarisés permet également de les utiliser au cours du procédé d'intégration pour contrôler différents paramètres du procédé d'intégration lui-même (température, pression durcissement).

Selon un mode de réalisation particulier, détaillé ci-dessous pour un composite fibreux à base de matrice thermoplastique (méth)acrylique, la matrice thermoplastique de l'article peut être obtenue par une polymérisation in-situ de monomères et/ou de prépolymères.

Le terme « polymérisation », dans le présent contexte, désigne le procédé de conversion d'un monomère ou d'un mélange de monomères en un polymère.

Le terme « polymérisation in-situ », dans le présent contexte, signifie que la polymérisation finale de la matrice thermoplastique a lieu autour du système électronique, et dans le cas du mode de réalisation ici développé autour du matériau de renforcement fibreux, afin de produire directement l'article composite. Le terme « monomère », dans le présent contexte, désigne une molécule qui peut subir une polymérisation.

Le terme « prépolymère », dans le présent contexte, désigne un polymère ou un oligomère dont des molécules sont capables d'entrer, par des groupes réactifs, dans une polymérisation supplémentaire.

Le terme « initiateur », tel qu'il est utilisé ci-après, désigne une espèce chimique qui forme un composé ou un composé intermédiaire qui démarre la polymérisation d'un monomère, qui est capable de relier avec succès un grand nombre d'autres monomères dans un composé polymère.

Le terme « imprégnation », tel qu'il est utilisé ci-après, désigne la pénétration de liquides monomères, oligomères ou polymères ou de mélanges de ceux-ci dans un assemblage de fibres.

La matrice thermoplastique (méth)acrylique peut être polymérisée à partir d'une composition liquide LC1, ou « sirop (méth)acrylique », comprenant un polymère (méth)acrylique (P1), un monomère (méth)acrylique (M1) ou un mélange de monomères (méth)acryliques (M1) et (M1+x), et au moins un initiateur (Init).

La viscosité dynamique de la composition liquide LC1 ou du sirop (méth)acrylique peut être dans une plage de 10 mPa*s à 10000 mPa*s, de préférence de 20 mPa*s à 7000 mPa*s et avantageusement de 20 mPa*s à 5000 mPa*s et plus avantageusement de 20 mPa*s à 2000 mPa*s et encore plus avantageusement entre 20 mPa*s et 1000 mPa*s. La viscosité du sirop peut facilement être mesurée avec un rhéomètre ou un viscosimètre. La viscosité dynamique est mesurée à 25°C. Si le sirop (méth)acrylique liquide a un comportement newtonien, ce qui signifie qu'il ne présente pas de fluidification sous cisaillement, la viscosité dynamique est indépendante du cisaillement dans un rhéomètre ou de la vitesse du mobile dans un viscosimètre. Si la composition liquide LC1 a un comportement non newtonien, ce qui signifie qu'elle présente une fluidification sous cisaillement, la viscosité dynamique est mesurée à un taux de cisaillement de 1s⁻¹ à 25 °C.

La composition liquide LC1 ou le sirop (méth)acrylique, pour imprégner le matériau fibreux, peut comprendre en particulier un monomère (méth)acrylique (M1), un polymère (méth)acrylique (P1) et au moins un initiateur (Init). Une fois polymérisé, le monomère (méth)acrylique (M1) est transformé en polymère (méth)acrylique (P2) comprenant les motifs monomères de monomère (méth)acrylique (M1).

En ce qui concerne le polymère (méth)acrylique (P1), il peut être mentionné des méthacrylates de polyalkyle ou des acrylates de polyalkyle. Selon un mode de réalisation préféré, le polymère (méth)acrylique (P1) est le poly(méthacrylate de méthyle) (PMMA).

Selon certains modes de réalisation, le PMMA peut être un mélange d'au moins un homopolymère et d'au moins un copolymère de MMA, ou un mélange d'au moins deux homopolymères ou deux copolymères de MMA ayant un poids moléculaire moyen différent, ou un mélange d'au moins deux copolymères de MMA ayant une composition de monomères différente.

Le copolymère de méthacrylate de méthyle (MMA) comprend de 70 % à 99,7 % en poids de méthacrylate de méthyle et de 0,3 à 30 % en poids d'au moins un monomère contenant au moins une insaturation éthylénique qui peut être copolymérisée avec le méthacrylate de méthyle.

Ces monomères sont bien connus, et on peut notamment mentionner les acides acrylique et méthacrylique et les (méth)acrylates d'alkyle dans lesquels le groupe alkyle contient de 1 à 12 atomes de carbone. En tant qu'exemples, il peut être mentionné l'acrylate de méthyle et le (méth)acrylate d'éthyle, de butyle ou de 2-éthylhexyle. De préférence, le comonomère est un acrylate d'alkyle dans lequel le groupe alkyle contient de 1 à 4 atomes de carbone.

Selon un premier mode de réalisation préféré, le copolymère de méthacrylate de méthyle (MMA) peut comprendre de 80 % à 99,9 %, avantageusement de 90 % à 99,9 % et plus avantageusement de 90 % à 99,9 % en poids de méthacrylate de méthyle, et de 0,1 % à 20 %, avantageusement de 0,1 % à 10 % et plus avantageusement de 0,1 % à 10 % en poids d'au moins un monomère contenant au moins une insaturation éthylénique qui peut être copolymérisée avec le méthacrylate de méthyle. De préférence, le comonomère est choisi parmi l'acrylate de méthyle et l'acrylate d'éthyle, et leurs mélanges.

La masse moléculaire moyenne en poids du polymère (méth)acrylique (P1) est avantageusement élevée, ce qui signifie supérieure à 50 000 g/mol et de préférence supérieure à 100 000 g/mol.

Le poids moléculaire moyen en poids peut être mesuré par chromatographie d'exclusion (SEC).

Le polymère (méth)acrylique (P1) est ici complètement soluble dans le monomère (méth)acrylique (M1) ou dans le mélange de monomères (méth)acryliques. Cela permet d'augmenter la viscosité du monomère (méth)acrylique (M1) ou du mélange de monomères (méth)acryliques. La solution obtenue est une composition liquide généralement appelée « sirop » ou « prépolymère ». La valeur de viscosité dynamique du sirop (méth)acrylique liquide peut être comprise entre 10 mPa.s et 10 000 mPa.s. La viscosité du sirop peut facilement être mesurée avec un rhéomètre ou un viscosimètre. La viscosité dynamique est mesurée à 25 °C. Avantageusement, la composition (méth)acrylique liquide, ou sirop, ne contient aucun solvant additionnel volontairement ajouté.

En ce qui concerne le monomère (méth)acrylique (M1), le monomère peut être choisi parmi l'acide acrylique, l'acide méthacrylique, les monomères acryliques d'alkyle, les monomères méthacryliques d'alkyle, les monomères acryliques d'hydroxyalkyle et les monomères méthacryliques d'hydroxyalkyle et leurs mélanges.

De préférence, le monomère (méth)acrylique (M1) peut être choisi parmi l'acide acrylique, l'acide méthacrylique, des monomères acryliques d'hydroxyalkyle, des monomères méthacryliques d'hydroxyalkyle, des monomères cryliques d'alkyle, des monomères méthacryliques d'alkyle et des mélanges de ceux-ci, le groupe alkyle contenant de 1 à 22 carbones, linéaires, ramifiés ou cycliques ; le groupe alkyle contenant de préférence 1 à 12 carbones, linéaires, ramifiés ou cycliques. Avantageusement, le monomère (méth)acrylique (M1) peut être choisi parmi le méthacrylate de méthyle, le méthacrylate d'éthyle, l'acrylate de méthyle, l'acrylate d'éthyle, l'acide méthacrylique, l'acide acrylique, l'acrylate de n-butyle, l'acrylate d'isobutyle, le méthacrylate de n-butyle, le méthacrylate d'isobutyle, l'acrylate de cyclohexyle, le méthacrylate de cyclohexyle, l'acrylate d'isobornyle, le méthacrylate d'isobornyle, l'acrylate d'hydroxyéthyle et le méthacrylate d'hydroxyéthyle et des mélanges de ceux-ci.

Selon un mode de réalisation préféré, au moins 50 % en poids, de préférence au moins 60 % en poids, du monomère (méth)acrylique (M1) est du méthacrylate de méthyle.

Selon un premier mode de réalisation plus préféré, au moins 50 % en poids, de préférence au moins 60 % en poids, plus préférablement au moins 70 % en poids, avantageusement au moins 80 % en poids et encore plus avantageusement 90 % en poids du monomère (M1) est un mélange de méthacrylate de méthyle avec facultativement au moins un autre monomère.

En ce qui concerne le matériau fibreux utilisé, il peut être tel que ceux présentés précédemment. Le matériau fibreux peut notamment être choisi parmi des fibres de verre ou des fibres de carbone, et être de forme unidimensionnelle, bidimensionnelle, ou encore tridimensionnelle.

En ce qui concerne la structure ou la composition du composite thermoplastique, celui-ci comprend au moins 20 % en poids de matériau fibreux par rapport au poids de la matrice thermoplastique, de préférence au moins 40 % de matériau fibreux, avantageusement au moins 50 % de matériau fibreux et plus avantageusement au moins 55 % de matériau fibreux.

En ce qui concerne le procédé de polymérisation utilisé pour obtenir la matrice (méth)acrylique thermoplastique, on peut citer la polymérisation radicalaire, la polymérisation anionique ou la photopolymérisation.

L'initiateur (INIT), peut par exemple être un initiateur radicalaire, activé par la chaleur. L'initiateur radicalaire peut être choisi parmi un composé comprenant un groupe peroxy ou des composés comprenant un groupe azoïque et, de préférence, parmi un composé comprenant un groupe peroxy.

De préférence, le composé comprenant un groupe peroxy comprend de 2 à 30 atomes de carbone.

De préférence, le composé comprenant un groupe peroxy est choisi parmi des peroxydes de diacyle, des peroxyesters, des peroxydicarbonates, des peroxydes de dialkyle, des peroxyacétals, un hydroperoxyde ou un peroxycétal.

L'initiateur peut notamment être choisi parmi le peroxyde de diisobutyryle, le peroxynéodécanoate de cumyle, le peroxydicarbonate de di(3-méthoxybutyle), le peroxynéodécanoate de 1,1,3,3-tétraméthylbutyle, le peroxynéoheptanoate de cumyle, le peroxydicarbonate de di-n-propyle, le peroxynéodécanoate de tert-amyle, le peroxydicarbonate de di-sec-butyle, le peroxydicarbonate de diisopropyle, le peroxydicarbonate de di(4-tert-butylcyclohexyle), le peroxydicarbonate de di-(2-éthylhexyle), le peroxynéodécanoate de tert-butyle, le peroxydicarbonate de di-n-butyle, le peroxydicarbonate de dicétyle, le peroxydicarbonate de dimyristyle, le peroxypivalate de 1,1,3,3-tétraméthylbutyle, le peroxynéoheptanoate de tert-butyle, le peroxypivalate de tert-amyle, le peroxypivalate de tert-butyle, le peroxyde de di-(3,5,5-triméthylhexanoyle), le peroxyde de dilauroyle, le peroxyde de didécanoyle, le 2,5-diméthyl-2,5-di(2-éthylhexanoylperoxy)-hexane, le peroxy-2-éthylhexanoate de 1,1,3,3-tétraméthylbutyle, le peroxy-2-éthylhexanoate de tert-amyle, le peroxyde de dibenzoyle, le peroxy-2-éthylhexanoate de tert-butyle, le peroxydiéthylacétate de tert-butyle, le peroxyisobutyrate de tert-butyle, le 1,1-di-(tert-butylperoxy)-3,3,5-triméthylcyclohexane, le 1,1-di(tert-amylperoxy)cyclohexane, le 1,1-di-(tert-butylperoxy)-cyclohexane, le peroxy-2-éthylhexylcarbonate de tert-amyle, le peroxyacétate de tert-amyle, le peroxy-3,5,5-triméthylhexanoate de tert-butyle, le 2,2-di-(tert-butylperoxy)-butane, le peroxyisopropylcarbonate de tert-butyle, le peroxy-2-éthylhexylcarbonate de tert-butyle, le peroxybenzoate de tert-amyle, le peroxyacétate de tert-butyle, le 4,4-di(tert-butylperoxy)valérate de butyle, le peroxybenzoate de tert-butyle, le di-tert-amylperoxyde, le peroxyde de dicumyle, le di-(2-tert-butyl-peroxyisopropyl)-benzène, le 2,5-diméthyl-2,5-di-(tert-butylperoxy)-hexane, le peroxyde de tert-butylcumyle, le 2,5-diméthyl-2,5-di(tert-butylperoxy)hexyne-3, le peroxyde de di-tert-butyle, le 3,6,9-triéthyl-3,6,9-triméthyl-1,4,7-triperoxonane, le 2,2'-azobisisobutyronitrile (AIBN), le 2,2'-azodi-(2-méthylbutyronitrile), l'azobisisobutyramide, le 2,2'-azobis(2,4-diméthylvaleronitrile), le 1,1'-azodi(hexahydrobenzonitrile) ou l'acide 4,4'-azobis(4-cyanopentanoïque).

D'une manière connue en soit, un mélange d'initiateurs peut être utilisé, par exemple un mélange d'un initiateur activé par la chaleur comme ci-dessus et d'un initiateur activé par absorption de rayonnement.

La proportion d'initiateur radicalaire par rapport aux monomères du mélange qui peut notamment varier de 100 à 2 000 ppm (en poids), de préférence de 200 à 1000 ppm en poids.

Le monomère (méth)acrylique (M1) ou les monomères (méth)acryliques dans la composition liquide LC1 représentent au moins 40 % en poids, de préférence 50 % en poids, avantageusement 60 % en poids et plus avantageusement 65 % en poids du sirop (méth)acrylique liquide total.

Le(s) monomère(s) (méth)acrylique(s) (M1) dans la composition liquide LC1 ou sirop (méth)acrylique sont présents dans des proportions comprises entre 40 % et 90 % en poids et de préférence entre 45 % et 85 % en poids de la composition comprenant un ou plusieurs monomère(s) (méth)acrylique(s) (M1) et le polymère (méth)acrylique (P1).

Le(s) polymère(s) (méth)acrylique(s) (P1) dans la composition liquide LC1 ou le sirop (méth)acrylique sont présents dans une proportion d'au moins 1 % en poids, de préférence au moins 5 % et plus préférablement au moins 10 % en poids, encore plus préférablement au moins 15 %, avantageusement au moins 18 % et plus avantageusement au moins 20 % en poids de la composition comprenant un ou plusieurs monomère(s) (méth)acrylique(s) (M1) et le polymère (méth)acrylique (P1).

Le(s) polymère(s) (méth)acrylique(s) (P1) dans le sirop (méth)acrylique liquide LC1 sont présents dans une proportion de pas plus de 50 % en poids, de préférence pas plus de 40 % et avantageusement pas plus de 30 % en poids de la composition comprenant le(s) monomère(s) (méth)acrylique(s) (M1) et le polymère (méth)acrylique (P1).

En ce qui concerne le procédé de préparation de l'article plusieurs procédés peuvent être utilisés : la stratification, la pultrusion, l'infusion, le moulage au sac sous vide, le moulage au sac sous pression, le moulage au sac en autoclave, le moulage par transfert de résine (MTR) et des variantes de ceux-ci, le procédé sous presse, l'enroulement filamentaire, le moulage par compression ou la formation par voie humide.

De manière avantageuse, l'article composite est préparé par moulage par transfert de résine ou par infusion.

Le moulage par transfert de résine est un procédé pour lequel on utilise un moule à deux côtés qui forme les deux surfaces du matériau composite. Le côté inférieur est un moule rigide. Le côté supérieur peut être un moule rigide ou flexible. Les moules flexibles peuvent se composer de matériaux composites, de silicone ou de films polymères extrudés comme le nylon. Les deux côtés s'assemblent pour produire une empreinte de moule. Le moulage par transfert de résine se caractérise par le fait que les matériaux de renforcement et le système électronique sont placés dans cette empreinte et que le moule est fermé avant l'introduction de la matrice. Le moulage par transfert de résine comprend de nombreuses variantes qui diffèrent par les aspects mécaniques du mode d'introduction de la résine dans le matériau de renforcement dans l'empreinte. Ces variantes comprennent toutes les possibilités, de l'infusion sous vide au moulage par transfert de résine assisté par vide (MTRAV). Ce procédé peut être mis en oeuvre soit à la température ambiante, soit à une température plus élevée. Avec un procédé par infusion, le sirop de prépolymère liquide doit effectivement avoir une viscosité adaptée au procédé de préparation du matériau composite polymère. Le sirop est aspiré dans le matériau fibreux présent dans un moule spécial par application d'un léger vide. Le sirop de prépolymère liquide infuse complètement le matériau fibreux et le mouille. Un avantage de ce procédé est la quantité élevée de matériau fibreux dans le composite.

Les procédés préférés pour la préparation des articles composites sont des procédés dans lesquels la résine liquide du matériau de matrice non encore polymérisé est transférée au matériau fibreux plus préférentiellement dans un moule. Ceci permet notamment d'éviter toute action postérieure de formage.

La Figure 5 est une représentation schématique simplifiée du procédé par infusion et du moule 500. La partie inférieure 501 du moule se compose d'un matériau rigide, tandis que la partie supérieure 502 du moule se compose d'un matériau flexible qui ferme hermétiquement le moule à l'aide de joints 503 qui assurent l'étanchéité du moule.

Entre la partie inférieure 501 et la partie supérieure 502 du moule, sont disposés le matériau fibreux et le système électronique 504. La résine liquide est distribuée avec un tuyau de distribution 505 qui pénètre dans le moule et un tuyau de vide 506. Quand un léger vide est appliqué, la résine liquide infuse le matériau fibreux et le système électronique 504 placés entre les deux parties du moule.

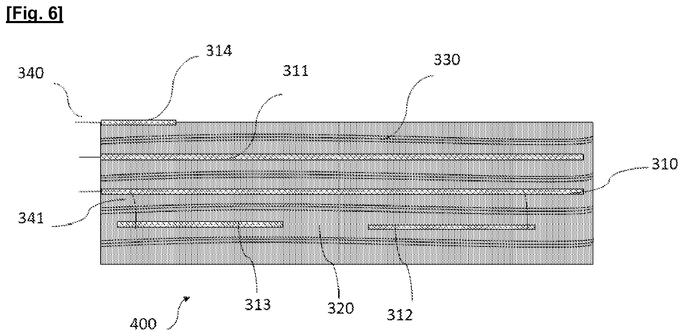

La Figure 6 représente un laminé thermoplastique composite 400 au sein duquel ont été intégrés réseaux de transducteurs 310, 311, 312, notamment des circuits 300 imprimés, tel celui représenté en Figure 4, dans une matrice thermoplastique 320.

Ainsi dans ce mode de réalisation, des tissus de fibres 330 ont été empilées les unes aux autres et des réseaux de transducteurs 310, 311, 312 ont été intercalés. Ceci ne représente pas forcément un cas réel d'empilement, mais permet d'exemplifier différents agencements réseaux de transducteurs dans le volume du laminé thermoplastique composite 400.

Le circuit de transducteurs imprimé peut, comme représenté par le circuit 310, être disposé en plein cœur du laminé, notamment au niveau de la « fibre neutre », de telle sorte à minimiser les phénomènes de traction ou de compression pour des articles fortement déformables.

Le circuit de transducteurs imprimés peut, comme représenté par les circuits 311, 312, 313, être disposé dans le volume mais plus en périphérie que le circuit 310. Dans des cas particuliers, le circuit de transducteurs imprimés peut, comme représenté par le circuit 314 affleurer la surface du laminé.

L'utilisation de circuits de transducteurs permet de limiter le nombre de câbles électriques 340, 341 et est relativement peu invasif.

### Recyclage

Dans le cadre de l'invention, l'utilisation d'un article composite comprenant une matrice thermoplastique, un polymère piézoélectrique thermoplastique, et éventuellement comportant un matériau de renfort fibreux permet de réduire significativement la quantité de matériaux non-recyclable à son strict minimum.

Ainsi l'article composite selon l'invention peut être recyclé, au moins en partie et préférablement quasi-entièrement voire en totalité.

Le recyclage est compris comme étant la récupération d'au moins une partie des matières constituant l'article pour une deuxième utilisation. Ceci signifie généralement le broyage de l'article et/ou la réutilisation des polymères thermoplastiques. Ceci peut également signifier, au moins selon certains modes de réalisation, qu'une partie des monomères utilisés pour la polymérisation des polymères thermoplastiques, notamment la matrice thermoplastique, peut être récupérée.

D'autres méthodes de recyclage particulièrement avantageuses ont également déjà été divulguées pour des polymères thermoplastiques, éventuellement des polymères (méth)acryliques : un recyclage par micro-ondes, impliquant la présence d'un composé sensibilisant à ce type de dépolymérisation (voir FR 3 080 625), un recyclage incluant une étape d'hydrolyse (voir FR 3 080 623), un recyclage par dépolymérisation courte (voir FR 3 080 622) ou encore un recyclage à bilan énergétique amélioré (FR 3 080 624).

### Exemple de réalisation spécifique

### Exemple préparatif 1 : Réalisation par sérigraphie d'un réseau de transducteurs piézoélectriques à base de P(VDF-TrFE)

Un réseau de six transducteurs a été imprimé à l'aide d'une machine de sérigraphie semi-automatique DEK 248, équipée d'un plateau aspirant, sur un substrat de PET thermostabilisé de 125 µm.

Le substrat a préalablement été nettoyé en salle blanche à l'aide d'un chiffon imbibé d'éthanol puis séché au pistolet ionisant. L'impression a été mise en œuvre comme suit :
(i) Impression à l'aide d'un écran polyester des électrodes inférieures, de 3,14 cm², en PEDOT:PSS (Encre Clevios Heraeus SV4) puis séchage à 120 °C pendant 10 minutes dans une étude ventilée ;
(ii) Impression à l'aide d'un écran polyester des couches piézoélectriques, de 3,8 cm², en P(VDF-TrFE) (Encre Piezotech^{®} FC20 Ink P) puis séchage à 120 °C pendant 20 minutes dans une étude ventilée ;
(iii) Impression à l'aide d'un écran polyester des électrodes supérieures, de 3,14 cm², en PEDOT:PSS (Encre Clevios Heraeus SV4) puis séchage à 120 °C pendant 10 minutes dans une étude ventilée ;
(iv) Impression à l'aide d'un écran polyester des pistes électriques en argent (Encre Dupont ME604), permettant l'utilisation d'un connecteur à nappe électronique au bord de la feuille de PET, puis séchage à 120 °C pendant 10 minutes dans une étude ventilée ; et,
(v) Recuit à 140 °C pendant 10 min dans une étuve ventilée.

Chaque transducteur a ensuite été polarisé individuellement par l'application d'une tension sinusoïdale, de 0 à 500 V, à une fréquence de 1 Hz, avec une augmentation de 25 V par période. La mesure du courant lors de l'étape de polarisation permet d'obtenir, après traitement informatique, la mesure de polarisation rémanente, reliée aux propriétés piézoélectriques. Tous les transducteurs possèdent une polarisation rémanente supérieure à 70 mC/m², indiquant de bonnes propriétés ferro- et piézoélectriques.

### Exemple 1 : Réalisation d'un article composite intégrant le réseau de transducteurs selon l'exemple 1.

Un montage classique d'infusion, avec une grille drainante a été mis en place. La grille drainante facilite le remplissage de la pièce.

Le réseau de transducteurs imprimées selon l'exemple préparatif 1 a été intercalé au milieu de six tissus de verre (Taffetas 600 g/m²), mesurant 21 cm x 29,7 cm.

Une attention particulière a été portée pour les connectiques, protégées par du ruban adhésion Kapton, afin de les laisser apparentes et éviter à la résine d'entrer en contact avec celles-ci.

Un sirop a été préparé par dissolution de 25 % en poids de polyméthacrylate de méthyle (PMMA V825 de la société Altuglas) dans du méthacrylate de méthyle (MMA) en présence de 325 ppm d'AIBN (azobisisobutyronitrile) et de 35 ppm de terpinolène (1,4-paramenthadiène). La dissolution a eu lieu à la température ambiante à 25 °C pendant 48 heures. La viscosité de la solution de sirop était de 513 mPa*s, mesurée à la température ambiante (25 °C) avec un rhéomètre cône/plan de la société Brookfield.

Le sirop de prépolymère formé a été infusé à l'aide d'une pompe à vide permettant le transfert du sirop à travers le tissu. La feuille a été imprégnée par infusion pendant 3 minutes. La feuille imprégnée par infusion a été placée dans un four pendant 4 heures à 60 °C et une étape de chauffage additionnelle de 30 minutes à 125 °C a eu lieu pour terminer la polymérisation du PMMA (en atteignant un taux de conversion de 100 % du monomère).

Le composite polymère a été récupéré par séparation des différents films de l'infusion et démoulage.

Une bonne adhérence entre le réseau de transducteurs piézoélectriques et la matrice composite a été observée.

Les propriétés piézoélectriques de chaque transducteur sont évaluées par :
A) la vérification de la génération d'un pic de tension sur un oscilloscope lors d'un impact simulé avec un marteau de choc, indiquant leur fonctionnalité.
B) le cas échéant, la mesure de capacité à l'aide d'un LCR meter, à 1 kHz ; et,

Tous les transducteurs présentent un pic de tension lors de l'impact simulé avec le marteau de choc et sont donc considérés comme étant fonctionnels après la fabrication de l'article composite.

Les résultats des mesures de capacités sont résumés dans la tableau 1.

### Exemple comparatif 1 : Réalisation d'un article composite intégrant des transducteurs PVDF

L'exemple comparatif 1 est réalisé de la même manière que l'exemple 1 sauf que le réseau imprimé des six transducteurs de P(VDF-TrFE) est remplacé par un six transducteurs à base de films PVDF (LDT1-028K de TE Connectivity) connectés par des câbles électriques. Les 12 câbles électriques sont rassemblés pour former une nappe sortant par un des côtés de l'article.

Aucun transducteur n'est fonctionnel après la fabrication de l'article lors de l'impact simulé avec le marteau de choc.

### Exemple comparatif 2 : Réalisation d'un article composite intégrant des transducteurs PZT

L'exemple comparatif 2 est réalisé de la même manière que l'exemple 1 sauf que le réseau imprimé des six transducteurs de P(VDF-TrFE) est remplacé par six transducteurs PZT (7BB-27-4 de Murata) connectés par des câbles électriques. Les 12 câbles électriques sont rassemblés pour former une nappe sortant par un des côtés de l'article.

Deux transducteurs se sont révélés comme n'étant plus fonctionnels lors de l'impact simulé avec le marteau de choc. Il est vraisemblable que du fait de leur caractère fragile, certains transducteurs ont été cassés lors de la fabrication de l'article composite et/ou lors de la propagation de l'onde de choc.

Les résultats des mesures de capacités sont résumés dans la tableau 1 (« - » indique qu'aucune mesure n'a été réalisée le transducteur n'étant pas fonctionnel).

**Tableau 1**

| | Capacitance (nF), à 1 kHz, 23 °C | | |
|---|---|---|---|
| Transducteur | P(VDF-TrFE) | PVDF | PZT |
| 1 | 5,9 | - | - |
| 2 | 6,3 | - | 17,0 |
| 3 | 5,0 | - | 21,8 |
| 4 | 5,4 | - | 22,6 |
| 5 | 6,1 | - | - |
| 6 | 5,2 | - | 19,8 |

## Revendications

1. Article composite (400) comprenant au moins un système électronique (310, 311, 312, 313), intégré en surface ou dans le volume, d'un composite thermoplastique, ledit composite thermoplastique comprenant une matrice thermoplastique (320) et au moins un matériau de renfort (330) ,
ledit système électronique (310, 311, 312, 313) comprenant au moins un transducteur piézoélectrique (10, 20, 30) et des moyens de transmission d'un signal électrique (13, 21, 23, 32, 33);
ledit transducteur piézoélectrique comprenant un polymère piézoélectrique essentiellement constitué, ou constitué, des motifs de répétition issus du fluorure de vinylidène, VDF, et du trifluorure de vinylidène, TrFE; la proportion molaire du motif issu du TrFE étant de 15% à 50% par rapport au nombre total de moles des motifs issus du VDF et du TrFE.

2. Article selon la revendication 1, dans lequel le ladite matrice thermoplastique est une matrice (méth)acrylique, préférentiellement comprenant un homopolymère de méthacrylate de méthyle, MMA, ou un copolymère comprenant au moins 70% en poids de MMA, ou leur mélange.

3. Article selon l'une quelconque des revendications 1 et 2, dans lequel ledit polymère piézoélectrique a une proportion molaire en motif de répétition issu du TrFE de 16% à 35%, préférentiellement de 17% à 32%, de manière davantage préférée de 18% à 27%, et de manière extrêmement préférée de 19% à 22%, par rapport au nombre total de moles des motifs issus du VDF et du TrFE.

4. Article selon l'une quelconque des revendications 1 à 3, dans lequel la température de Curie du polymère piézoélectrique est strictement supérieure à 80°C, ou supérieure ou égale à 85°C, ou supérieure ou égale à 90°C, ou supérieure ou égale à 95°C, ou supérieure ou égale à 100°C, ou supérieure ou égale à 105°C, ou supérieure ou égale à 110°C, ou supérieure ou égale à 115°C, ou supérieure ou égale à 120°C, ou supérieure ou égale à 125°C, ou supérieure ou égale à 130°C, ou supérieure ou égale à 135°C, ou supérieure ou égale à 140°C, voire supérieure ou égale à 145°C.

5. Article selon l'une quelconque des revendications 1 à 4, dans lequel ledit au moins un transducteur est une fibre (20) comprenant une âme conductrice intérieure (21) constituant une première électrode, un revêtement intermédiaire (22) comprenant ledit au moins un polymère piézoélectrique adhérent à ladite âme conductrice et un revêtement externe conducteur (23) constituant une seconde électrode.

6. Article selon l'une quelconque des revendications 1 à 4, dans lequel ledit au moins un transducteur (30) et/ou les moyens de transmission du signal électrique (32, 33) sont obtenus par des méthodes d'impression électronique sur substrat (31) ;
la méthode d'impression étant préférentiellement choisie parmi: le revêtement par centrifugation, la pulvérisation ou atomisation, l'enduction notamment avec une barre ou un tire-film, l'enduction avec une tête à fente, l'immersion,
l'impression à rouleaux, l'impression en sérigraphie,
l'impression en flexographie, l'impression en lithographie, l'électrospinning ou l'impression par jet d'encre.

7. Article selon l'une quelconque des revendications 1 à 4, dans lequel ledit transducteur comprend un film (11) de polymère piézoélectrique.

8. Article selon l'une quelconque des revendications 1 à 7, dans lequel le polymère piézoélectrique a une épaisseur de 10⁻⁶ m à 5.10⁻⁵ m, préférentiellement de 2.10⁻⁶ m à 2,5.10⁻⁵ m, et de manière extrêmement préférée de 5.10⁻⁶ à 1,5.10⁻⁵ m.

9. Article selon l'une quelconque des revendications 1 à 8, comprenant une pluralité de transducteurs piézoélectriques formant un réseau (200, 300).

10. Article selon l'une quelconque des revendications 1 à 9, **caractérisé en ce que** ledit système électronique est intégré à la matrice thermoplastique par un procédé de mise en œuvre dont la température ne dépasse pas la température de Curie du polymère piézoélectrique.

11. Article selon l'une quelconque des revendications 1 à 10, dans lequel le matériau de renfort est un matériau constitué de fibres longues ou continues, notamment de fibres de verre ou de fibres de carbone.

12. Article selon l'une quelconque des revendications 1 à 11, dans lequel ledit système électronique est intégré à la matrice thermoplastique par un procédé de polymérisation in-situ.

13. Article selon l'une quelconque des revendications 1 à 12, choisi parmi une structure multicouche composite pour la distribution ou le stockage de l'hydrogène, une structure pour pâle d'éolienne, une barre d'armature pour béton, ou encore un pack pour batteries.

14. Utilisation d'un système électronique pour assurer un contrôle du déroulement d'un procédé d'intégration dudit système électronique à une matrice thermoplastique, le système électronique et la matrice thermoplastique étant destinés à former un article composite selon l'une quelconque des revendications 1 à 13.

15. Utilisation de l'article composite selon l'une quelconque des revendications 1 à 13 pour la mesure et/ou la surveillance de propriétés dudit article, notamment pour en assurer un contrôle de santé de structure.

## Patentansprüche

1. Verbundartikel (400), welcher mindestens ein elektronisches System (310, 311, 312, 313) umfasst, das auf der Oberfläche oder in dem Volumen integriert ist, aus einem thermoplastischen Verbundwerkstoff, wobei der thermoplastische Verbundwerkstoff eine thermoplastische Matrix (320) und mindestens ein Verstärkungsmaterial (330) umfasst;
wobei das elektronische System (310, 311, 312, 313) mindestens einen piezoelektrischen Wandler (10, 20, 30) und Mittel zur Übertragung eines elektrischen Signals (13, 21, 23, 32, 33) umfasst;
wobei der piezoelektrische Wandler ein piezoelektrisches Polymer umfasst, das im Wesentlichen aus den Wiederholungseinheiten besteht oder daraus besteht, die von Vinylidenfluorid, VDF, und Vinylidentrifluorid, TrFE, abgeleitet sind;
wobei der molare Anteil der von TrFE abgeleiteten Einheit 15 % bis 50 % beträgt, bezogen auf die Gesamtzahl der Mole der von VDF und von TrFE abgeleiteten Einheiten.

2. Artikel nach Anspruch 1, wobei die thermoplastische Matrix eine (Meth)acrylmatrix ist, die vorzugsweise ein Homopolymer von Methylmethacrylat, MMA oder ein Copolymer, das mindestens 70 Gew.-% MMA umfasst, oder eine Mischung davon umfasst.

3. Artikel nach einem der Ansprüche 1 und 2, wobei das piezoelektrische Polymer einen molaren Anteil der von TrFE abgeleiteten Wiederholungseinheit von 16 % bis 35 %, vorzugsweise von 17 % bis 32 %, stärker bevorzugt von 18 % bis 27 %, aufweist, und besonders bevorzugt von 19 % bis 22 %, bezogen auf die Gesamtzahl der Mole der von VDF und TrFE abgeleiteten Einheiten.

4. Artikel nach einem der Ansprüche 1 bis 3, wobei die Curie-Temperatur des piezoelektrischen Polymers streng größer als 80 °C oder größer als oder gleich 85 °C oder größer als oder gleich 90 °C oder größer als oder gleich 95 °C oder größer als oder gleich 100 °C oder größer als oder gleich 105 °C oder größer als oder gleich 110 °C oder größer als oder gleich 115 °C oder größer als oder gleich 120 °C oder größer als oder gleich 125 °C oder größer als oder gleich 130 °C oder größer als oder gleich 135 °C oder größer als oder gleich 140 °C oder sogar größer als oder gleich 145 °C ist.

5. Artikel nach einem der Ansprüche 1 bis 4, wobei der mindestens eine Wandler eine Faser (20) ist, die einen eine erste Elektrode bildenden inneren leitenden Kern (21), eine das mindestens eine piezoelektrische Polymer umfassende Zwischenbeschichtung (22), die an dem leitfähigen Kern haftet, und eine leitfähige Außenbeschichtung (23), die eine zweite Elektrode bildet, umfasst.

6. Artikel nach einem der Ansprüche 1 bis 4, wobei der mindestens eine Wandler (30) und/oder die Mittel zur Übertragung des elektrischen Signals (32, 33) durch elektronische Druckverfahren auf einem Substrat (31) erhalten werden;
wobei das Druckverfahren vorzugsweise ausgewählt ist aus: Schleuderbeschichten, Sprühen oder Feinstzerstäuben, Beschichten, insbesondere mit einem Beschichtungsstab oder Filmziehgerät, Beschichten mit einem Schlitzkopf, Tauchen, Walzendruck, Siebdruck, Flexodruck, Lithographie, Elektrospinning oder Tintenstrahldruck.

7. Artikel nach einem der Ansprüche 1 bis 4, wobei der Wandler einen piezoelektrischen Polymerfilm (11) umfasst.

8. Artikel nach einem der Ansprüche 1 bis 7, wobei das piezoelektrische Polymer eine Dicke von 10⁻⁶ m bis 5 · 10⁻⁵ m, vorzugsweise von 2 · 10⁻⁶ m bis 2,5 · 10⁻⁵ m und besonders bevorzugt von 5 · 10⁻⁶ bis 1,5 · 10⁻⁵ m aufweist.

9. Artikel nach einem der Ansprüche 1 bis 8, welcher mehrere piezoelektrische Wandler umfasst, die ein Array (200, 300) bilden.

10. Artikel nach einem der Ansprüche 1 bis 9, **dadurch gekennzeichnet, dass** das elektronische System in die thermoplastische Matrix durch ein Verarbeitungsverfahren integriert ist, dessen Temperatur die Curie-Temperatur des piezoelektrischen Polymers nicht überschreitet.

11. Artikel nach einem der Ansprüche 1 bis 10, wobei das Verstärkungsmaterial ein Material ist, das aus Lang- oder Endlosfasern, insbesondere Glasfasern oder Kohlefasern, besteht.

12. Artikel nach einem der Ansprüche 1 bis 11, wobei das elektronische System durch ein In-situ-Polymerisationsverfahren in die thermoplastische Matrix integriert ist.

13. Artikel nach einem der Ansprüche 1 bis 12, der aus einer Mehrschichtverbundstruktur zur Verteilung oder Speicherung von Wasserstoff, einer Windturbinenblatt-Struktur, einem Betonbewehrungsstab oder auch einem Batteriepack ausgewählt ist.

14. Verwendung eines elektronischen Systems zur Sicherung einer Steuerung des Ablaufs eines Verfahrens zur Integration des elektronischen Systems mit einer thermoplastischen Matrix, wobei das elektronische System und die thermoplastische Matrix dazu bestimmt sind, einen Verbundartikel nach einem der Ansprüche 1 bis 13 zu bilden.

15. Verwendung des Verbundartikels nach einem der Ansprüche 1 bis 13 zur Messung und/oder Überwachung von Eigenschaften des Artikels, insbesondere zur Sicherstellung eines Structural Health Monitoring desselben.

## Claims

1. Composite article (400) comprising at least one electronic system (310, 311, 312, 313), integrated onto the surface or in the volume of a thermoplastic composite, said thermoplastic composite comprising a thermoplastic matrix (320) and at least one reinforcing material (330),
said electronic system (310, 311, 312, 313) comprising at least one piezoelectric transducer (10, 20, 30) and electrical signal transmission means (13, 21, 23, 32, 33);
said piezoelectric transducer comprising a piezoelectric polymer essentially consisting of, or consisting of, repeating units derived from vinylidene fluoride, VDF, and vinylidene trifluoride, TrFE;
the molar proportion of the unit derived from TrFE being from 15% to 50% relative to the total number of moles of the units derived from VDF and TrFE.

2. Article according to Claim 1, in which said thermoplastic matrix is a (meth)acrylic matrix, preferentially comprising a methyl methacrylate, MMA, homopolymer, or a copolymer comprising at least 70% by weight of MMA, or a mixture thereof.

3. Article according to either of Claims 1 and 2, in which said piezoelectric polymer has a molar proportion of TrFE-based repeating units of from 16% to 35%, preferentially from 17% to 32%, more preferably from 18% to 27%, and extremely preferably from 19% to 22%, relative to the total number of moles of units derived from VDF and TrFE.

4. Article according to any one of Claims 1 to 3, in which the Curie temperature of the piezoelectric polymer is strictly greater than 80°C, or greater than or equal to 85°C, or greater than or equal to 90°C, or greater than or equal to 95°C, or greater than or equal to 100°C, or greater than or equal to 105°C, or greater than or equal to 110°C, or greater than or equal to 115°C, or greater than or equal to 120°C, or greater than or equal to 125°C, or greater than or equal to 130°C, or greater than or equal to 135°C, or greater than or equal to 140°C, or even greater than or equal to 145°C.

5. Article according to any one of Claims 1 to 4, in which said at least one transducer is a fibre (20) comprising an inner conductive core (21) constituting a first electrode, an intermediate coating (22) comprising said at least one piezoelectric polymer adhering to said conductive core, and an outer conductive coating (23) constituting a second electrode.

6. Article according to any one of Claims 1 to 4, in which said at least one transducer (30) and/or the electrical signal transmission means (32, 33) are obtained via electronic printing methods on a substrate (31);
the printing method being preferentially chosen from:
spin coating, spray coating, coating notably with a bar or a film spreader, slot-die coating, dip coating, roll-to-roll printing, screen printing, flexographic printing, lithographic printing, electrospinning or inkjet printing.

7. Article according to any one of Claims 1 to 4, in which said transducer comprises a film (11) of piezoelectric polymer.

8. Article according to any one of Claims 1 to 7, in which the piezoelectric polymer has a thickness of from 10⁻⁶ m to 5x10⁻⁵ m, preferentially from 2x10⁻⁶ m to 2.5x10⁻⁵ m, and extremely preferably from 5x10⁻⁶ to 1.5x10⁻⁵ m.

9. Article according to any one of Claims 1 to 8, comprising a plurality of piezoelectric transducers forming an array (200, 300).

10. Article according to any one of Claims 1 to 9, **characterized in that** said electronic system is integrated into the thermoplastic matrix via an operating process whose temperature does not exceed the Curie temperature of the piezoelectric polymer.

11. Article according to any one of Claims 1 to 10, in which
the reinforcing material is a material consisting of long or continuous fibres, notably glass fibres or carbon fibres.

12. Article according to any one of Claims 1 to 11, in which said electronic system is integrated into the thermoplastic matrix via an in-situ polymerization process.

13. Article according to any one of Claims 1 to 12, chosen from a multilayer composite structure for hydrogen distribution or storage, a structure for a wind turbine blade, a rebar for concrete, or a battery pack.

14. Use of an electronic system for monitoring the progress of a process for integrating said electronic system into a thermoplastic matrix, the electronic system and the thermoplastic matrix being intended to form a composite article according to any one of Claims 1 to 13.

15. Use of the composite article according to any one of Claims 1 to 13, for measuring and/or monitoring properties of said article, notably for Structural Health Monitoring.
